(19) Europäisches Patentamt
European Patent Office
Office européen des brevets

(11) **EP 1 837 998 A2**

(12) **EUROPEAN PATENT APPLICATION**

(43) Date of publication:
**26.09.2007 Bulletin 2007/39**

(51) Int Cl.:
***H03M 13/00*** (2006.01)

(21) Application number: **07002653.9**

(22) Date of filing: **07.02.2007**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **07.02.2006 KR 20060011664**

(71) Applicant: **Samsung Electronics Co., Ltd.
Suwon-si, Gyeonggi-Do (KR)**

(72) Inventors:
 • **Kim, Dong-Ho
 Yeongtong-gu,
 Suwon-si,
 Gyeonggi-do (KR)**
 • **You, Cheol-Woo
 Yeongtong-gu,
 Suwon-si,
 Gyeonggi-do (KR)**
 • **Kim, Yung-Soo
 Yeongtong-gu,
 Suwon-si,
 Gyeonggi-do (KR)**

 • **Lee, Ye-Hoon
 Yeongtong-gu,
 Suwon-si,
 Gyeonggi-do (KR)**
 • **Park, Hyo-Yol
 Yeongtong-gu,
 Suwon-si,
 Gyeonggi-do (KR)**
 • **Kim, Kwang-Soon
 Yeongtong-gu,
 Suwon-si,
 Gyeonggi-do (KR)**
 • **Whang, Keum-Chan
 Yeongtong-gu,
 Suwon-si,
 Gyeonggi-do (KR)**

(74) Representative: **Grünecker, Kinkeldey,
 Stockmair & Schwanhäusser
 Anwaltssozietät
 Maximilianstrasse 58
 80538 München (DE)**

(54) **Method for puncturing a low density parity check code**

(57) Provided is a method for puncturing a Low Density Parity Check (LDPC) code that is expressed in a factor graph configured by a bit node and a check node connected to an edge and is decoded by a parity check matrix with an information region and a parity region. A mother code with a code rate is generated. Bit nodes configuring the parity region are grouped in a block unit. A transmission code rate and the number of bits to be punctured in the mother code according to the transmission code rate are set. A puncturing process in either the block unit or a bit unit or both is performed according to the transmission code rate. All codes with required code rates can be obtained. The LDPC code puncturing method can be flexibly applied to Hybrid Automatic Repeat Request (H-ARQ) and Incremental Redundancy (IR) systems.

FIG.3

EP 1 837 998 A2

**Description**

**BACKGROUND OF THE INVENTION**

1. Field of the Invention

The present invention relates generally to a Low Density Parity Check (LDPC) code, and in particular, to a method for puncturing an LDPC code.

2. Description of the Related Art

LDPC codes are attracting great interest in a coding scheme suitable for Fourth-Generation (4G) mobile communication systems, because they have a superior performance and lower decoding complexity than turbo codes and can be processed in parallel at a high rate.

In 1962 Gallager first defined the LDPC codes as linear block codes using a parity check matrix H with a large number of 0's. Herein, the '0' represents a zero element. The implementation technology has not been made due to code complexity, and the LDPC codes have been almost forgotten for a long time. Mackay and Neal have rediscovered the LDPC codes and have verified that they have a superior performance using a simple probabilistic decoding method of Gallager.

A sparse random parity check matrix H with a small number of 1's defines the LDPC code. Herein, the '1' represents an example of a non-zero element. The parity check matrix H is used for determining whether a received encoded signal has been decoded normally. An error has not occurred, if a product of the received encoded signal and the parity check matrix H is 0 . After a predetermined parity check matrix is designed to produce zero when the LDPC codes are multiplied by all received encoded signals, an encoding operation in an encoder of a transmitting side is performed on the basis of the designed parity check matrix.

The parity check matrix H is randomly generated, in which overlapping between any two columns is not greater than 1. Herein, the weight indicates the number of non-zero elements, i.e., the number of 1's. The overlap between two columns is their inner product. The weight of a row or column is less than a code length. The parity check matrix H is constructed by LDPC codes for this reason.

Techniques capable of generating LDPC codes at various code rates are divided into two methods. The first method is designed in a manner such that parity check matrices with various code rates can be included in one main parity check matrix. This method generates the parity check matrices based on the various code rates suitable for constraints while generating the main parity check matrix. The LDPC codes generated from the above-described method can have the superior performance, and a performance at each code rate can be predicted. However, this method can neither obtain various code rates nor can it be applied to full Incremental Redundancy (IR) scheme or partial IR scheme of an Hybrid Automatic Repeat Request (H-ARQ) system requiring the technology of combining code bits due to a mismatch between code bit streams at code rates.

The second method performs a puncturing process suitable for a code rate after an encoding process. After a transmitting stage performs the puncturing process in a regular pattern, a decoder of a receiving stage inserts a Log Likelihood ratio (LLR) value of 0 and a probability value of 0.5 into a punctured bit node, such that a decoding process is possible. The puncturing process can easily generate a desired code rate and does not increase additional complexity in the encoding process. Moreover, the puncturing process can be applied to the H-ARQ technology as in a conventional Rate Compatible Punctured Turbo (RCPT) scheme. However, a performance of the second method is inferior to that of the first method based on LDPC codes with an optimal parity check matrix at each code rate. Various schemes are being provided in order to improve performance degradation due to puncturing of an LDPC code. Specifically, a block LDPC code puncturing scheme exhibits an improved performance close to a channel capacity limit.

Because the block LDPC code puncturing scheme is performed in a block unit, a desired performance can be expected at a particular code rate. However, the puncturing scheme cannot be applied at other code rates.

**SUMMARY OF THE INVENTION**

Accordingly, the present invention has been designed to solve the above and other problems occurring in the conventional art. Therefore, it is an aspect of the present invention to provide a puncturing method that can minimize performance degradation when a Low Density Parity Check (LDPC) code is punctured which is generated from an LDPC matrix with an almost zigzag parity pattern.

It is another aspect of the present invention to provide a method for puncturing a Low Density Parity Check (LDPC) code that can be applied at any code rate by applying puncturing processes in both block and bit units.

In accordance with an aspect of the present invention, there is provided a method for puncturing a Low Density Parity Check (LDPC) code that is expressed in a factor graph configured by a bit node and a check node connected to an edge and is decoded by a parity check matrix with a parity region configured by one column with a weight of 3 and columns with a weight of 2 forming a dual-diagonal matrix, including generating a mother code with a code rate; grouping bit nodes configuring the parity region in a block unit corresponding to z bit nodes; determining a transmission code rate for a data transmission and the number of bits to be punctured, P, in the mother code according to the transmission code rate;

and performing a puncturing process in either the block unit or a bit unit or a dual puncturing process in both the block unit and the bit unit according to the transmission code rate for the data transmission.

Preferably, the code rate of the mother code is 1/3.

Preferably, when the transmission code rate is less than ½, the puncturing process in the bit unit is performed for $\left\lfloor \dfrac{P}{32} \right\rfloor$ or $\left( \left\lfloor \dfrac{P}{32} \right\rfloor + 1 \right)$ bits in each of (2n + 1)$^{th}$ blocks where n = 0, 1, ..., 31.

Preferably, when the transmission code rate is ½, (2n + 1)$^{th}$ blocks are punctured where n = 0, 1,..., 31.

Preferably, when the transmission code rate is more than ½ and less than 2/3, the puncturing process in the block unit is performed for (4n + 1)$^{th}$ and (4n + 3)$^{th}$ blocks where n = 0, 1, ... , 15 and the puncturing process in the bit unit is performed for $\left\lfloor \dfrac{P - 32z}{16} \right\rfloor$ or $\left( \left\lfloor \dfrac{P - 32z}{16} \right\rfloor + 1 \right)$ bits in each of (4n + 2)$^{th}$ blocks where n = 0, 1, ..., 15.

Preferably, when the transmission code rate is 2/3, (4n + 1)$^{th}$, (4n + 2)$^{th}$, and (4n + 3)$^{th}$ blocks are punctured where n = 0, 1, ..., 15.

Preferably, when the transmission code rate is more than 2/3 and less than 4/5, the puncturing process in the block unit is performed for (8n +1)$^{th}$, (8n + 2)$^{th}$, (8n + 3)$^{th}$, (8n + 5)$^{th}$, (8n + 6)$^{th}$, and (8n + 7)$^{th}$ blocks where n = 0, 1, ... , 7 and the puncturing process in the bit unit is performed for $\left\lfloor \dfrac{P - 48z}{8} \right\rfloor$ or $\left( \left\lfloor \dfrac{P - 48z}{8} \right\rfloor + 1 \right)$ bits in each of (8n +4)$^{th}$ blocks where n = 0, 1, ..., 7.

Preferably, when the transmission code rate is 4/5, the puncturing process in the block unit is performed for (8n +1)$^{th}$, (8n + 2)$^{th}$, (8n + 3)$^{th}$, (8n + 5)$^{th}$, (8n + 6)$^{th}$, and (8n + 7)$^{th}$ blocks where n = 0, 1, ..., 7.

Preferably, when the transmission code rate is more than 4/5 and less than 8/9, the puncturing process in the block unit is performed for (16n +j)$^{th}$ blocks where n = 0, 1, ..., 7 and j = 1, 2, 3, 4, 5, 6, 7, 9, ..., 15 and the puncturing process in the bit unit is performed for $\left\lfloor \dfrac{P - 56z}{4} \right\rfloor$ or $\left( \left\lfloor \dfrac{P - 56z}{4} \right\rfloor + 1 \right)$ bits in each of (16n + 8)$^{th}$ blocks where n = 0, 1, ..., 7.

Preferably, when the transmission code rate is 8/9, the puncturing process in the block unit is performed for (16n + j)$^{th}$ blocks where n = 0, 1, ..., 7 and j = 1, 2, 3, 4, 5, 6, 7, 9,..., 15.

## BRIEF DESCRIPTION OF THE DRAWINGS

The above and other aspects and aspects of the present invention will be more clearly understood from the following detailed description taken in conjunction with the accompanying drawings, in which:

FIG. 1 illustrates a structure of a parity check matrix of a Low Density Parity Check (LDPC) code provided for an Orthogonal Frequency Division Multiple Access (OFDMA) PHY of Institute of Electrical and Electronics Engineers (IEEE) 802.16e;
FIG. 2 illustrates a structure of a parity pattern $H_{b2}$ of the parity check matrix of FIG. 1;
FIG. 3 is a preferred factor graph illustrating the terminology defined in a puncturing method of the present invention;
FIG. 4 is a factor graph illustrating a k-Step Recoverable (k-SR) node;
FIG. 5 is a factor graph illustrating the $H_{b2}$ pattern of FIG. 2;
FIG. 6 is a conceptual diagram illustrating a puncturing pattern in a block unit in the puncturing method in accordance with the present invention;
FIGS. 7A to 7C schematically illustrate a puncturing pattern according to a code rate in a puncturing method in accordance with the present invention, respectively;
FIGS. 8A and 8B schematically illustrate a puncturing pattern for generating a code with a code rate ¾ in a puncturing method in accordance with the present invention, respectively; and
FIGS. 9A and 9B schematically illustrate a puncturing pattern for generating a code with a code rate 3/8 in a puncturing method in accordance with the present invention, respectively.

## DETAILED DESCRIPTION OF THE PREFERRED EMBODIMENTS

A Low Density Parity Check (LDPC) code puncturing method in accordance with the present invention will be described in detail herein below with reference to the accompanying drawings.

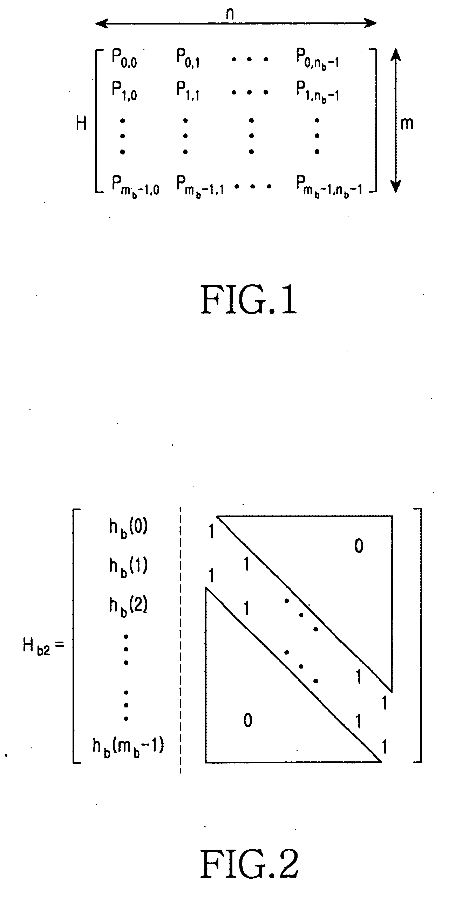

FIG. 1 illustrates a structure of a parity check matrix of a LDPC code provided for an Orthogonal Frequency Division Multiple Access (OFDMA) PHY of Institute of Electrical and Electronics Engineers (IEEE) 802.16e. In FIG. 1, $P_{i,j}$ is a z × z permutation matrix or a z × z zero matrix. A matrix H is extended from a $m_b$ × $n_b$ binary base matrix $H_b$, where n = z·$n_b$, m = z·$m_b$,

and $z \geq 1$. Replacing elements of ones configuring the base matrix with the $z \times z$ permutation matrix, and replacing elements of zeros with the $z \times z$ zero matrix extend the base matrix.

The base matrix is divided into a pattern $H_{b1}$ mapped to systematic bits and a pattern $H_{b2}$ mapped to parity check bits. $H_b = \left\lfloor (H_{b1})_{m_b \times k_b} \vdots (H_{b2})_{m_b \times m_b} \right\rfloor$. $H_{b2}$ is divided into a vector $h_b$ with a weight 3 and $H'_{b2}$ with a dual-diagonal structure. $H_{b2} = \left\lfloor h_b \vdots H'_{b2} \right\rfloor$.

FIG. 2 illustrates a structure of a parity pattern $H_{b2}$ of the parity check matrix of FIG. 1. Except for dual-diagonal elements of $H'_{b2}$, all the remaining elements are 0.

The base matrix includes $h_b(0)=1$ , $h_b(m_b-1)=1$ , and $h_b(j)=1(0<j<(m_b-1))$.

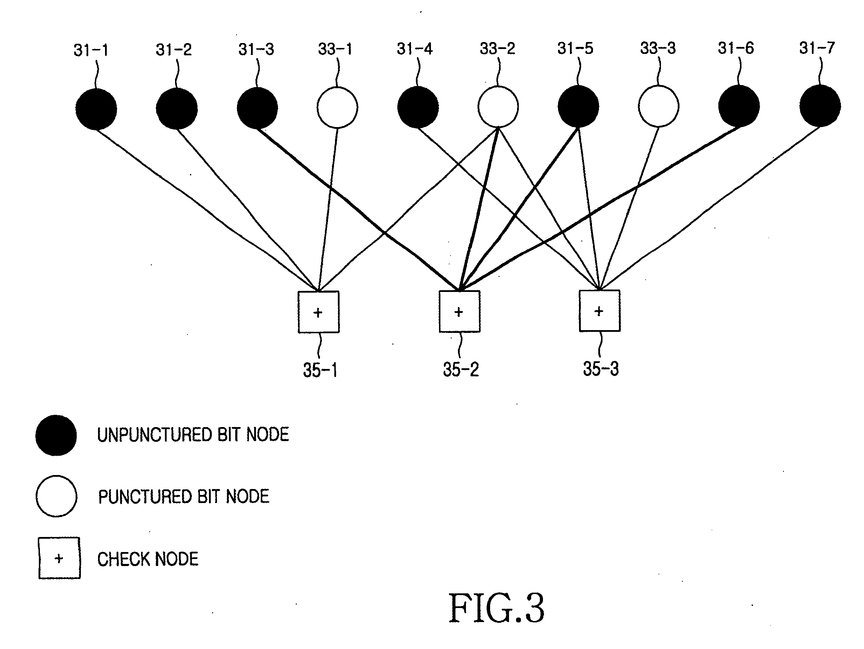

FIG. 3 is a factor graph illustrating the terminology defined in a puncturing method of the present invention. In FIG. 3, unpunctured bit nodes 31-1 ~ 31-7 are referred to as 0-Step Recoverable (0-SR) nodes. When at least one Survived Check (SC) node of neighboring check nodes 35-1 ~ 35-3 (connected to an edge) is a check node 35-2 connected to only the 0-SR bit nodes 31-1 -31-7 except its own punctured bit node, a punctured bit node 33-2 is referred to as a 1-SR node. When a Binary Erasure Channel (BEC) is considered, the 1-SR node is a node recoverable through one decoding process at the time of iterative decoding.
When step-by-step recoverable nodes are generalized and defined, a punctured bit node connected to at least one SC node that is connected to at least one $(k-1)$-SR node and m-SR nodes $(0 \leq m \leq k-1)$ is a k-SR node.

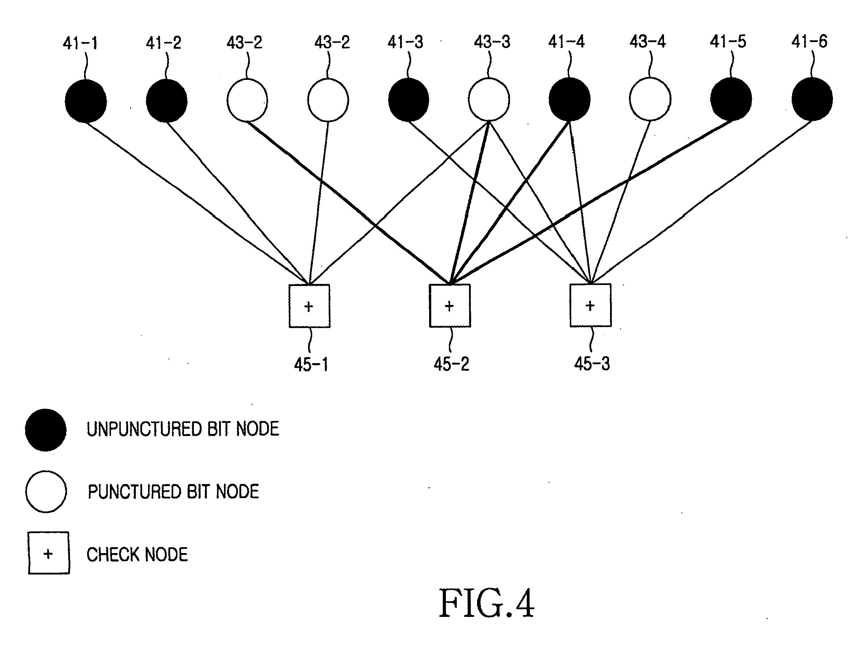

FIG. 4 illustrates an example of the k-SR node. Bit nodes 41-1 ~ 41-6 are 0-SR nodes or bit nodes recovered up to the $(k-1)$ steps. A punctured bit node 43-3 connected to an SC node 45-2 that is connected to at least one $(k-1)$-SR node 43-2 and m-SR nodes 41-4 and 41-5 among check nodes 45-1 - 45-3 is a k-SR node. When a BEC is considered, the k-SR node is a node recoverable through k decoding processes at the time of iterative decoding.

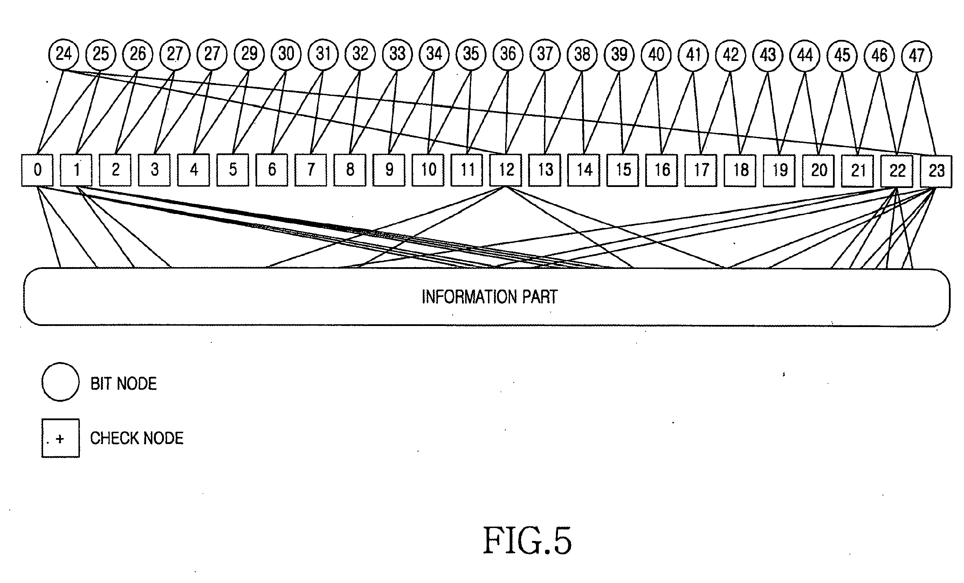

FIG. 5 is a factor graph illustrating the $H_{b2}$ pattern of FIG. 2. It can be seen that bit nodes and check nodes on the factor graph are connected in a type of zig-zag pattern. Specifically, it can be sent that a first column configuring a first parity pattern is connected to three check nodes.

In accordance with the present invention, a puncturing method performs a puncturing process in a block unit with respect to particular code rates 1/3, ½, 2/3, and so on, and punctures some of bits configuring specific blocks after the puncturing process in the block unit, thereby obtaining a desired code rate incapable of being acquired in only the puncturing process in the block unit.

For convenience of explanation, there will be described an example of a mother code with a code rate R (=1/3) in 64 rows $\times$ 96 columns based on an information part configured by blocks of 32 columns and a parity part configured by blocks of 64 columns in the present invention.

In order to obtain a code rate ½ from the mother code, one bit node block connected to all check node blocks can be punctured. In other words, when 1st, 3rd, 5th, 7th, ... , 61st , and 63rd block columns of the parity part are punctured, the code rate ½ is obtained because 32 block columns are punctured.

On the other hand, a code rate 2/3 can be obtained because 16 block columns are additionally punctured when even block columns placed between the block columns punctured in the puncturing pattern based on the code rate ½ of the parity part are alternately punctured such that the number of 2-SR nodes is maximal in the puncturing pattern based on the code rate ½.

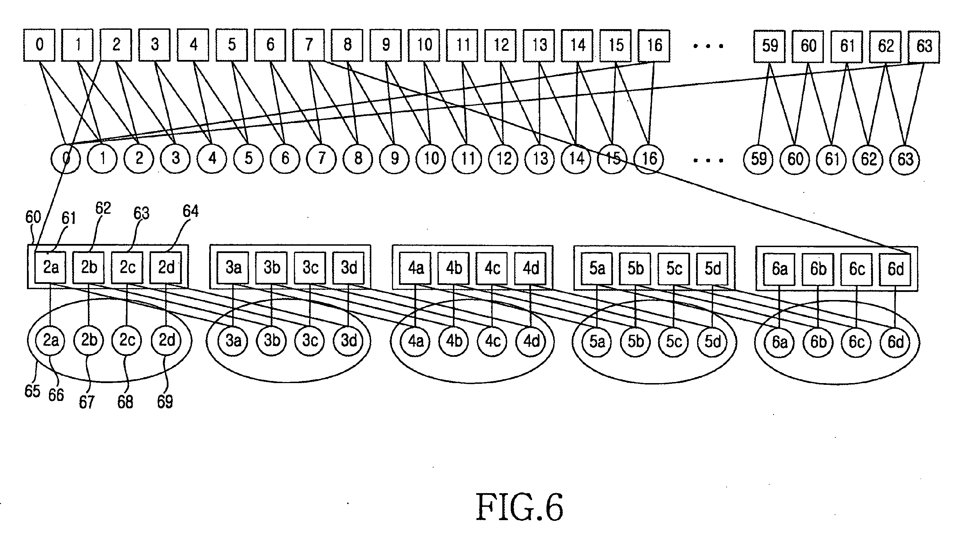

FIG. 6 is a conceptual diagram illustrating a puncturing pattern in a block unit in the puncturing method in accordance with the present invention.

As illustrated in FIG. 6, one check node block is configured by a plurality of check nodes and one bit node block is configured by a plurality of bit nodes. When one node block is configured by four nodes in this embodiment, each check node block 60 is configured by four check nodes 61, 62, 63, and 64 and each bit node block 65 is configured by four bit nodes 66, 67, 68, and 69.

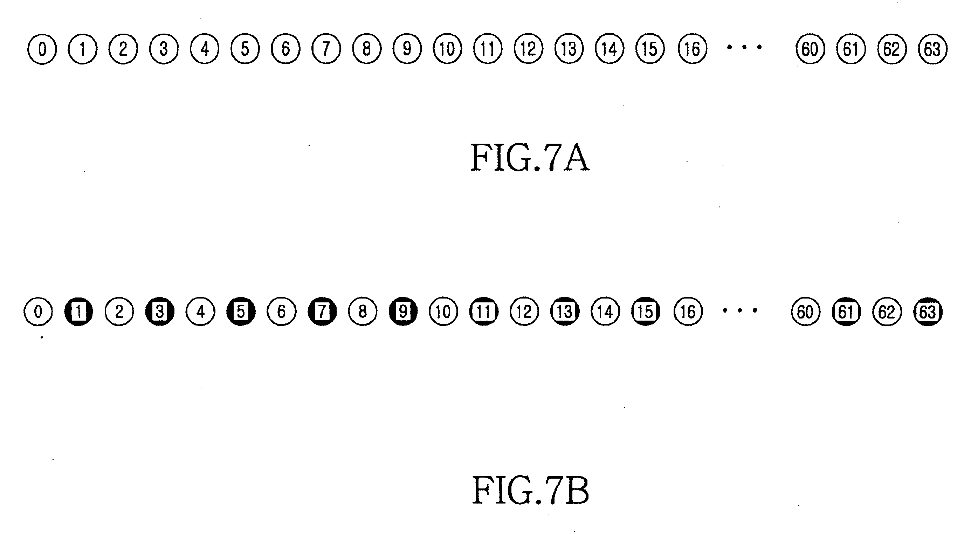

FIGS. 7A to 7C illustrate a puncturing pattern according to a code rate in a puncturing method in accordance with the present invention, respectively.

FIG. 7A schematically illustrates only a parity part of a mother code with a code rate of 1/3 that is expressed by 0th to 63rd bit node blocks.

FIG. 7B schematically illustrates a puncturing pattern for generating a code with a code rate of ½. In this puncturing pattern, even bit node blocks are punctured in the mother code with the code rate 1/3 of FIG. 7A.

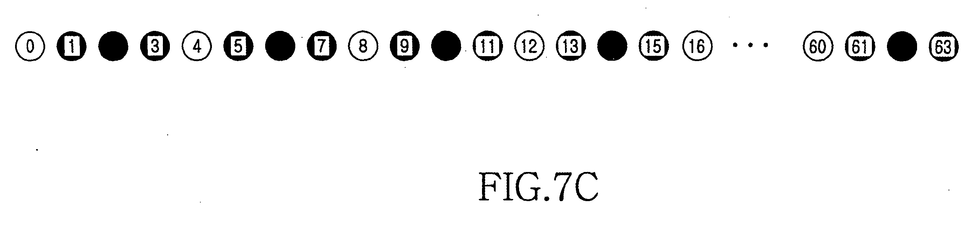

FIG. 7C schematically illustrates a puncturing pattern for generating a code with a code rate of 2/3. In this puncturing pattern, bit node blocks placed between punctured bit node blocks are alternately punctured in the code with the code rate ½ of FIG. 7B.

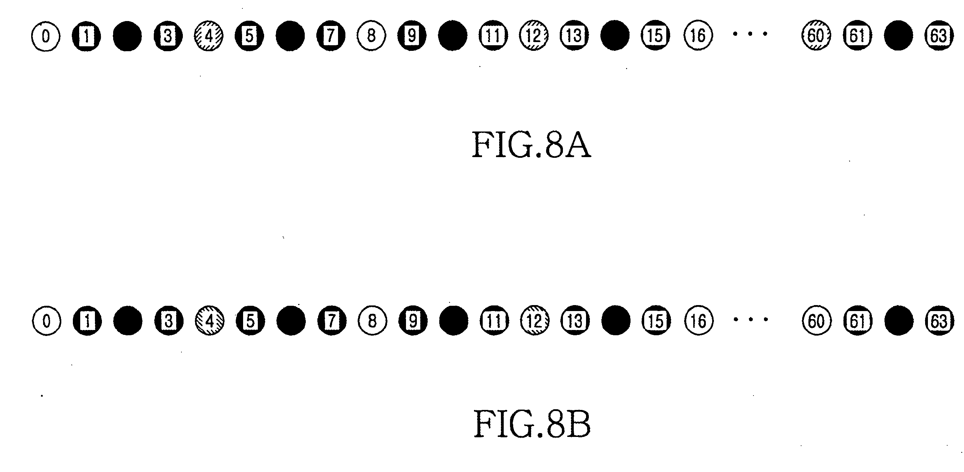

FIGS. 8A and 8B schematically illustrate a puncturing pattern for generating a code with a code rate of ¾ in a puncturing method in accordance with the present invention, respectively.

To generate a code with the code rate of ¾, $(53 + 1/3)z$ bits are to be punctured among 64z parity bits. Herein, z is the number of bit nodes configuring a block.

The code with the code rate of ¾ can be obtained when $(5 + 1/3)z (= (16/3)z)$ bit nodes are additionally punctured in the code with the code rate 2/3. Accordingly, a puncturing process in a bit unit is to be performed for the remaining unpunctured bit node blocks. Candidate blocks to be additionally punctured become (b (= 8n + 4))th blocks where n = 0, 1, ... , 7.

The puncturing process in the bit unit can consider a scheme for puncturing all bit nodes to be punctured in one block or performing the puncturing process in the bit unit for puncturing target bit nodes distributed over many candidate blocks. This process applies the scheme for performing the puncturing process in the bit unit for many candidate blocks.

In FIG. 8A, a puncturing process is performed for (16/3)z puncturing target bit nodes uniformly distributed over eight candidate bit node blocks. Whereas, in FIG. 8B, a puncturing process is performed for (5 + 1/3) z bit nodes distributed over (5 + 1/3) blocks. In this case, the (b (= 8n + 4))th block serving as the candidate block becomes a 4-SR node, and the (b (= 8n + 3))th and (b (= 8n + 5))th blocks serving as the candidate blocks become 3-SR nodes.

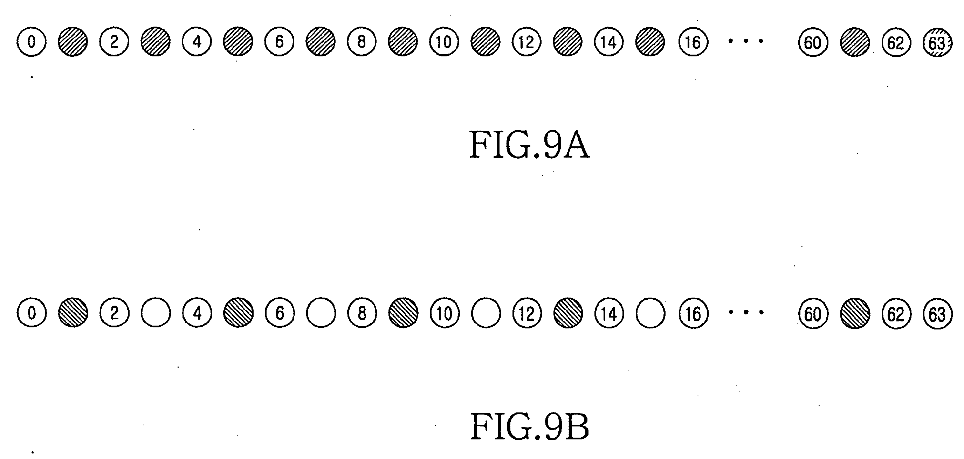

FIGS. 9A and 9B schematically illustrate a puncturing pattern for generating a code with a code rate of 3/8 in a puncturing method in accordance with the present invention, respectively.

When R = 3/8, 32*(z/3) bits are to be punctured. In the puncturing pattern of FIG. 9A, a puncturing process is performed for 32*(z/3) puncturing target bits distributed over b (= 2n + 1) candidate bit node blocks (or 32 blocks). In the puncturing pattern of FIG. 9B, a puncturing process is performed for puncturing target bits distributed over (10 + z/3) blocks.

If the number of bits to be punctured, P, is 32z (R < ½) when the puncturing pattern is generalized according to a code rate, b (= 2n) blocks are transferred where n = 0, 1, ... , 31 and $\left\lfloor \dfrac{P}{32} \right\rfloor$ or $\left( \left\lfloor \dfrac{P}{32} \right\rfloor + 1 \right)$ bits are punctured in each of the b (= 2n + 1) blocks where n = 0, 1, ..., 31.

Alternatively, if $P$ = 32z (R = ½), (b = (2n))th blocks are transferred where n = 0, 1, ... , 31, and (b = (2n + 1))th blocks are punctured where n = 0, 1, ... , 31.

If 32z < P < 48z (1/2 < R < 2/3), b (= 4n) blocks are transferred where n = 0, 1, ..., 15 and $\left\lfloor \dfrac{P-32z}{16} \right\rfloor$ or $\left( \left\lfloor \dfrac{P-32z}{16} \right\rfloor + 1 \right)$ bits are punctured in each of the (b = (4n + 1))th, (b = (4n + 3))th, and (b = (4n + 2))th blocks where n = 0, 1, ..., 15.

If P = 60z (R = 8/9), (b = (16n))th blocks are transferred where n = 0, 1, ... , 7, and (b = (16n + j))th blocks are punctured where n = 0, 1, ... , 31 and j =1,2,..., 15.

As described above, loss due to puncturing can be minimized when an improved puncturing pattern is designed and applied with respect to a zigzag parity region (or a dual-diagonal region with a single 3-weight column) in which coding is possible at coding complexity of 0(N).

In an LDPC code puncturing method of the present invention, puncturing processes are applied in both block and bit units. Therefore, all codes with required code rates can be obtained. The LDPC code puncturing method can be flexibly applied to Hybrid Automatic Repeat Request (H-ARQ) and Incremental Redundancy (IR) systems.

## Claims

1. A method for puncturing a Low Density Parity Check (LDPC) code that is expressed in a factor graph configured by a bit node and a check node connected through an edge and is decoded by a parity check matrix with an information region and a parity region, the method comprising the :

    generating a mother code with a code rate;
    grouping bit nodes configuring the parity region in a block unit corresponding to z bit nodes;
    determining a transmission code rate for a data transmission and the number of bits to be punctured, P, in the mother code according to the transmission code rate; and
    performing a puncturing process in either the block unit or a bit unit or a dual puncturing process in both the block unit and the bit unit according to the transmission code rate for the data transmission.

2. The method of claim 1, wherein performing the puncturing process comprises :

    determining importance of a block according to a degree of performance degradation at a puncturing time;
    determining whether one of the puncturing process in either the block unit or the bit unit and the dual puncturing process is to be performed while considering the number of bits to be punctured according to the transmission code rate and the total number of bits of a plurality of blocks with identical importance; and
    performing the puncturing process from a block with low importance when the number of bits to be punctured is equal to the total number of bits of the plurality of blocks with the identical importance and only the puncturing process in the block unit achieves the transmission code rate.

3. The method of claim 2, wherein the step of performing the puncturing process further comprises:

    selecting a plurality of blocks with lowest importance, considering a mutual edge connection state between bits of the blocks, and performing the puncturing process in the bit unit, when the number of bits to be punctured is different from the total number of bits of the plurality of blocks with the identical importance and the transmission code rate is achieved by only the puncturing process in the bit unit.

4. The method of claim 3, wherein the step of performing the puncturing process further comprises :

performing the puncturing process from a block with the lowest importance according to the transmission code rate, when the transmission code rate is achieved by the dual puncturing process; and
selecting a plurality of blocks from among the remaining blocks after the puncturing process in the block unit, considering a mutual edge connection state between bits of the blocks, and performing the puncturing process in the bit unit.

5. The method of claim 1, wherein the parity region is configured by one column with a weight of 3 and columns with a weight of 2 forming a dual-diagonal matrix.

6. The method of claim 5, wherein the code rate of the mother code is 1/3.

7. The method of claim 6, wherein the step of performing the puncturing process comprises :

selecting the puncturing process in the bit unit when the transmission code rate is less than ½; and
performing the puncturing process in the bit unit

for $\left\lfloor \dfrac{P}{32} \right\rfloor$ or $\left( \left\lfloor \dfrac{P}{32} \right\rfloor + 1 \right)$ bits in each of

$(2n + 1)^{th}$ blocks where n = 0, 1, ... , 31.

8. The method of claim 6, wherein the step of performing the puncturing process comprises :

selecting the puncturing process in the block unit when the transmission code rate is ½; and
puncturing $(2n + 1)^{th}$ blocks where n = 0, 1, ..., 31.

9. The method of claim 6, wherein the step of performing the puncturing process comprises :

selecting the dual puncturing process when the transmission code rate is more than ½ and less than 2/3;
performing the puncturing process in the block unit for $(4n + 1)^{th}$ and $(4n + 3)^{th}$ blocks where n = 0, 1, ..., 15; and

performing the puncturing process in the bit unit

for $\left\lfloor \dfrac{P - 32z}{16} \right\rfloor$ or $\left( \left\lfloor \dfrac{P - 32z}{16} \right\rfloor + 1 \right)$

bits in each of $(4n + 2)^{th}$ blocks where n = 0, 1, ..., 15.

10. The method of claim 6, wherein the step of performing the puncturing process comprises :

selecting the puncturing process in the block unit when the transmission code rate is 2/3; and
puncturing $(4n + 1)^{th}$, $(4n + 2)^{th}$, and $(4n + 3)^{th}$ blocks where n = 0, 1,..., 15.

11. The method of claim 6, wherein the step of performing the puncturing process comprises :

selecting the dual puncturing process when the transmission code rate is more than 2/3 and less than 4/5;
performing the puncturing process in the block unit for $(8n +1)^{th}$, $(8n + 2)^{th}$, $(8n + 3)^{th}$, $(8n + 5)^{th}$, $(8n + 6)^{th}$, and $(8n + 7)^{th}$ blocks where n = 0, 1, ..., 7; and

performing the puncturing process in the bit unit

for $\left\lfloor \dfrac{P - 48z}{8} \right\rfloor$ or $\left( \left\lfloor \dfrac{P - 48z}{8} \right\rfloor + 1 \right)$ bits

in each of $(8n +4)^{th}$ blocks where n = 0, 1, ..., 7.

12. The method of claim 6, wherein the step of performing the puncturing process comprises:

selecting the puncturing process in the block unit when the transmission code rate is 4/5; and
performing the puncturing process in the block unit for $(8n +1)^{th}$, $(8n + 2)^{th}$, $(8n + 3)^{th}$, $(8n + 5)^{th}$, $(8n + 6)^{th}$, and $(8n + 7)^{th}$ blocks where n = 0, 1, ..., 7.

13. The method of claim 6, wherein the step of performing the puncturing process comprises :

selecting the dual puncturing process when the transmission code rate is more than 4/5 and less than 8/9;
performing the puncturing process in the block unit for $(16n + j)^{th}$ blocks where n = 0, 1, ..., 7 and j = 1, 2, 3, 4, 5, 6, 7, 9, ..., 15; and

performing the puncturing process in the bit unit

$$\text{for } \left\lfloor \frac{P - 56z}{4} \right\rfloor \text{ or } \left( \left\lfloor \frac{P - 56z}{4} \right\rfloor + 1 \right) \text{ bits}$$

in each of $(16n + 8)^{th}$ blocks where n = 0, 1, ..., 7.

14. The method of claim 6, wherein the step of performing the puncturing process comprises :

selecting the puncturing process in the block unit when the transmission code rate is 8/9; and performing the puncturing process in the block unit for $(16n + j)^{th}$ blocks where n = 0, 1, ..., 7 and j = 1, 2, 3, 4, 5, 6, 7, 9, ..., 15.

$$H = \begin{bmatrix} P_{0,0} & P_{0,1} & \cdots & P_{0,n_b-1} \\ P_{1,0} & P_{1,1} & \cdots & P_{1,n_b-1} \\ \vdots & \vdots & \vdots & \vdots \\ P_{m_b-1,0} & P_{m_b-1,1} & \cdots & P_{m_b-1,n_b-1} \end{bmatrix}$$

# FIG.1

$$H_{b2} = \begin{bmatrix} h_b(0) & & & & & & \\ h_b(1) & & & & & & \\ h_b(2) & & & & & & \\ \vdots & & & & & & \\ h_b(m_b-1) & & & & & & \end{bmatrix}$$

# FIG.2

FIG.3

FIG.4

BIT NODE

CHECK NODE

FIG.5

EP 1 837 998 A2

FIG.6

EP 1 837 998 A2

12

(0) (1) (2) (3) (4) (5) (6) (7) (8) (9) (10) (11) (12) (13) (14) (15) (16) ・・・ (60) (61) (62) (63)

# FIG.7A

(0) **(1)** (2) **(3)** (4) **(5)** (6) **(7)** (8) **(9)** (10) **(11)** (12) **(13)** (14) **(15)** (16) ・・・ (60) **(61)** (62) **(63)**

# FIG.7B

EP 1 837 998 A2

FIG.7C

EP 1 837 998 A2

FIG.8A

FIG.8B

FIG.9A

FIG.9B